# EUROPEAN PATENT APPLICATION

(11) **EP 2 397 324 A1**
(43) Date of publication of application: **21.12.2011**
(21) Application number: 10741287.6
(22) Date of filing: 12.02.2010
(51) Int. Cl.: B32B 27/00, B32B 7/02, G02F 1/1333, G09F 9/30

(54) **MULTILAYER BODY, METHOD FOR PRODUCING SAME, ELECTRONIC DEVICE MEMBER, AND ELECTRONIC DEVICE**

(30) Priority: 16.02.2009 JP 2009032790
(71) Applicant: LINTEC Corporation, Tokyo 173-0001 (JP)
(72) Inventor: HOSHI Shinichi, Tokyo 173-0001 (JP); KONDO Takeshi, Tokyo 173-0001 (JP)
(74) Representative: Albrecht, Thomas
(86) International application number: PCT/JP2010/052058
(87) International publication number: WO 2010/093010

(57) **Abstract**

Disclosed is a laminate comprising a gas barrier layer and a conductor layer, the gas barrier layer being formed of a material that includes at least an oxygen atom, a carbon atom, and a silicon atom, the gas barrier layer having an oxygen atom content that gradually decreases from a surface of the gas barrier layer in a depth direction, and having a carbon atom content that gradually increases from the surface of the gas barrier layer in the depth direction. Also disclosed are a method of producing the laminate, an electronic device member that includes the laminate, and an electronic device that includes the electronic device member. The above laminate exhibits an excellent gas barrier capability and excellent interlayer adhesion, and the conductor layer of the above laminate has high surface smoothness. Since the above laminate enables an increase in flexibility and a reduction in weight, the laminate may suitably be used as an electronic device member for a display (e.g., organic EL display), a solar battery, or the like. Since the laminate enables roll-to-roll mass production, cost can be reduced.

## Description

### TECHNICAL FIELD

The present invention relates to a_laminate that includes a gas barrier layer and a conductor layer, and exhibits an excellent gas barrier capability and excellent interlayer adhesion, a method of producing the laminate, an electronic device member that includes the laminate, and an electronic device that includes the electronic device member.

### BACKGROUND ART

In recent years, use of a transparent plastic film as an electrode substrate instead of a glass sheet has been proposed for displays (e.g., liquid crystal display and electroluminescence (EL) display) in order to implement a reduction in thickness, a reduction in weight, an increase in flexibility, and the like.
However, since a plastic film tends to allow water vapor, oxygen, and the like to pass through as compared with a glass sheet, elements provided in a display may deteriorate. Moreover, a plastic film has low surface smoothness.

In order to solve this problem, Patent Documents 1 and 2 disclose a conductive electrode substrate in which a smooth surface layer and an inorganic barrier layer are stacked on a plastic substrate, and a conductive electrode layer is formed as the outermost layer, for example.
However, the gas barrier capability of the resulting conductive electrode substrate is not necessarily satisfactory. Moreover, since the smooth surface layer and the inorganic barrier layer, and these layers and the electrode (conductive electrode layer) have insufficient adhesion, it may be necessary to provide a functional thin film that improves adhesion between the layers. This complicates the production process, and it may become difficult to implement a reduction in thickness, a reduction in weight, and an increase in flexibility.

Patent Document 3 discloses a transparent conductive gas barrier film in which a gas barrier layer and a transparent electrode layer are formed on an ion-implanted layer formed one side of a plastic film by plasma ion implantation using at least one gas selected from a rare gas, hydrogen, nitrogen, and ammonia gas as a plasma source.

### RELATED-ART DOCUMENT

### PATENT DOCUMENT

Patent Document 1: JP-A-2003-154596
Patent Document 2: JP-A-2006-264118
Patent Document 3: JP-A-2008-270115

### SUMMARY OF THE INVENTION

### PROBLEMS TO BE SOLVED BY THE INVENTION

The invention was conceived in view of the above situation. An object of the invention is to provide a laminate that includes a gas barrier layer and a conductor layer, and exhibits an excellent gas barrier capability and excellent interlayer adhesion, a method of producing the laminate, an electronic device member that includes the laminate, and an electronic device that includes the electronic device member.

### MEANS FOR SOLVING THE PROBLEMS

The inventors of the invention conducted extensive studies in order to achieve the above object. As a result, the inventors found that a laminate that includes a conductor layer, and a gas barrier layer that is formed of a material that includes at least an oxygen atom, a carbon atom, and a silicon atom, and has a configuration in which the oxygen atom content rate gradually decreases and the carbon atom content rate gradually increases from the surface of the gas barrier layer in the depth direction, exhibits an excellent gas barrier capability and excellent interlayer adhesion.
The inventors also found that the gas barrier layer can be easily and efficiently formed by implanting ions into a polyorganosiloxane compound-containing layer of a formed body that includes the polyorganosiloxane compound-containing layer in its surface area. These findings have led to the completion of the invention.

According to a first aspect of the invention, there is provided the following laminate (see (1) to (7)).
(1) A laminate including a gas barrier layer and a conductor layer, the gas barrier layer being formed of a material that includes at least an oxygen atom, a carbon atom, and a silicon atom, the gas barrier layer having an oxygen atom content rate that gradually decreases from a surface of the gas barrier layer in a depth direction, and having a carbon atom content rate that gradually increases from the surface of the gas barrier layer in the depth direction.
(2) The laminate according to (1), wherein the surface layer part of the gas barrier layer has an oxygen atom content rate of 10 to 70%, a carbon atom content rate of 10 to 70%, and a silicon atom content rate of 5 to 35%, based on the total content of oxygen atoms, carbon atoms, and silicon atoms.
(3) The laminate according to (1), wherein the surface layer part of the gas barrier layer has a peak position of binding energy of 2P electron of the silicon atom (hereinafter referred to as a silicon atom 2p electron binding energy peak position) determined by X-ray photoelectron spectroscopy (XPS) of 102 to 104 eV.
(4) The laminate according to (1), further including an inorganic compound layer.

(5) The laminate according to (1), wherein the gas barrier layer is a layer produced by implanting ions into a polyorganosiloxane compound-containing layer.
(6) The laminate according to (5), wherein the ions have been produced by ionizing at least one gas selected from the group consisting of nitrogen, oxygen, argon, and helium.
(7) The laminate according to (5), wherein the polyorganosiloxane compound is a polyorganosiloxane that includes a repeating unit shown by the following formula (a) or (b),

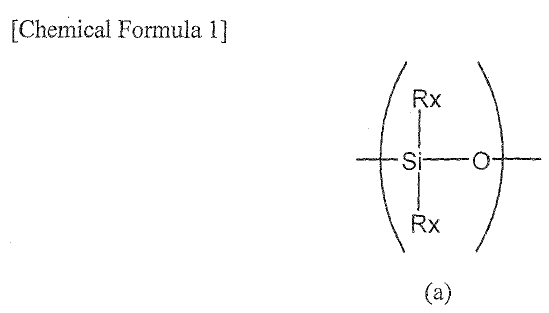

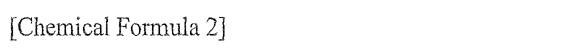

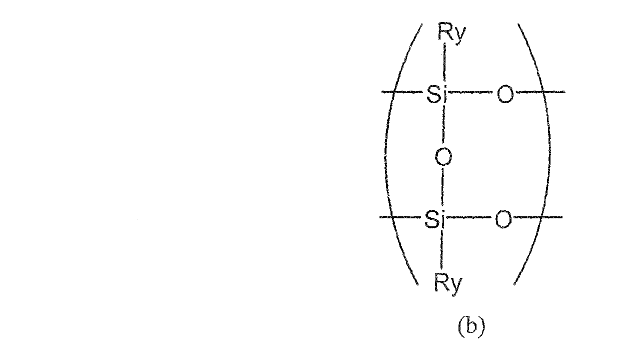

wherein Rx and Ry individually represent a hydrogen atom or a non-hydrolyzable group such as a substituted or unsubstituted alkyl group, a substituted or unsubstituted alkenyl group, or a substituted or unsubstituted aryl group. Note that a plurality of Rx in the formula (a) and a plurality of Ry in the formula (b) may respectively be either the same or different, but a case where both Rx in the formula (a) represent a hydrogen atom is excluded.

According to a second aspect of the invention, there is provided the following method of producing a laminate (see (8) to (11)).
(8) A method of producing a laminate including a gas barrier layer and a conductor layer, the method including a step (I) implanting ions into a polyorganosiloxane compound-containing layer of a formed body that includes the polyorganosiloxane compound-containing layer in its surface area to form the gas barrier layer.
(9) The method according to (8), wherein the ions implanted in the step (I) are produced by ionizing at least one gas selected from the group consisting of nitrogen, oxygen, argon, and helium.
(10) The method according to (8), wherein the ions are implanted in the step (I) by plasma ion implantation.
(11) The method according to (8), wherein the ions are implanted into the polyorganosiloxane compound-containing layer in the step (I) while transferring a long formed body that includes the polyorganosiloxane compound-containing layer in its surface layer part in a given direction.

According to a third aspect of the invention, there is provided the following electronic device member (see (12)).
(12) An electronic device member including the laminate according to any one of (1) to (7).
According to a fourth aspect of the invention, there is provided the following electronic device (see (13)).
(13) An electronic device including the electronic device member according to (12).

### EFFECTS OF THE INVENTION

The above laminate exhibits an excellent gas barrier capability and excellent interlayer adhesion (adhesion between the gas barrier layer and the conductor layer)
The conductor layer of the above laminate has high surface smoothness.
The above laminate may be efficiently produced by the above method.
Since the above laminate enables an increase in flexibility and a reduction in weight, the laminate may suitably be used as an electronic device member for a display (e.g., organic EL display), a solar battery, or the like. Since the laminate enables roll-to-roll mass production, cost can be reduced.
Since the above electronic device member that includes the above laminate exhibits an excellent gas barrier capability, excellent interlayer adhesion, and the like, the electronic device member may suitably be used for an electronic device (e.g., display and solar battery).

### BRIEF DESCRIPTION OF THE DRAWINGS

FIG. 1 is a view showing the layer configuration of a laminate according to one embodiment of the invention.
FIG. 2 is a view showing a schematic configuration of a plasma ion implantation apparatus used in connection with the invention.
FIG. 3 is a view showing a schematic configuration of a sputtering apparatus used in connection with the invention.
FIG. 4 is a view showing the oxygen atom content rate (%), the carbon atom content rate (%), and the silicon atom content rate (%) in the gas barrier layer of the formed article 1 of Example 1.
FIG. 5 is a view showing the oxygen atom content rate (%), the carbon atom content rate (%), and the silicon atom content rate (%) in the gas barrier layer of the formed article 2 of Example 2.
FIG. 6 is a view showing the oxygen atom content rate (%), the carbon atom content rate (%), and the silicon atom content rate (%) in the gas barrier layer of the formed article 3 of Example 3.
FIG. 7 is a view showing the oxygen atom content rate (%), the carbon atom content rate (%), and the silicon atom content rate (%) in the gas barrier layer of the formed article 4 of Example 4.
FIG. 8 is a view showing the oxygen atom content rate (%), the carbon atom content rate (%), and the silicon atom content rate (%) in the gas barrier layer of the formed article 5 of Example 5.
FIG. 9 is a view showing the oxygen atom content rate (%), the carbon atom content rate (%), and the silicon atom content rate (%) in the gas barrier layer of the formed article 6 of Example 6.
FIG. 10 is a view showing the oxygen atom content rate (%), the carbon atom content rate (%), and the silicon atom content rate (%) in the gas barrier layer of the formed article 7 of Example 7.
FIG. 11 is a view showing the oxygen atom content rate (%), the carbon atom content rate (%), and the silicon atom content rate (%) in the gas barrier layer of the formed article 8 of Example 8.
FIG. 12 is a view showing the oxygen atom content rate (%), the carbon atom content rate (%), and the silicon atom content rate (%) in the gas barrier layer of the formed article 9 of Example 9.
FIG. 13 is a view showing the oxygen atom content rate (%), the carbon atom content rate (%), and the silicon atom content rate (%) in the gas barrier layer of the formed article 10 of Example 10.
FIG. 14 is a view showing the oxygen atom content rate (%), the carbon atom content rate (%), and the silicon atom content rate (%) in the gas barrier layer of the formed article 19 of Comparative Example 1.
FIG. 15 is a view showing the XPS analysis results for the distribution of the silicon atom 2p electron binding energy of the formed article 2 of Example 2.

### DESCRIPTION OF EXEMPLARY EMBODIMENTS

A laminate, a method of producing the same, an electronic device member, and an electronic device according to embodiments of the invention are described in detail in below.

### 1) Laminate and method of producing the same

A laminate according to one embodiment of the invention includes a gas barrier layer and a conductor layer, the gas barrier layer being formed of a material that includes at least an oxygen atom, a carbon atom, and a silicon atom, the gas barrier layer having an oxygen atom content rate that gradually decreases from the surface of the gas barrier layer in the depth direction, and having a carbon atom content rate that gradually increases from the surface of the gas barrier layer in the depth direction. Note that the surface of the gas barrier layer includes the interface of the gas barrier layer with another layer (e.g., conductor layer).

### (Gas barrier layer)

The gas barrier layer (hereinafter may be referred to as "layer A") included in the laminate according to one embodiment of the invention is formed of a material that includes at least an oxygen atom, a carbon atom, and a silicon atom, the gas barrier layer having an oxygen atom content rate that gradually decreases from the surface of the gas barrier layer in the depth direction, and having a carbon atom content rate that gradually increases from the surface of the gas barrier layer in the depth direction.

The material that includes at least an oxygen atom, a carbon atom, and a silicon atom is not particularly limited insofar as the material is a polymer that includes at least an oxygen atom, a carbon atom, and a silicon atom. From the viewpoint of obtaining a more excellent gas barrier capability, it is preferable that the surface layer part of the gas barrier layer have an oxygen atom content rate of 10 to 70%, a carbon atom content rate of 10 to 70%, and a silicon atom content rate of 5 to 35%, based on the total content (=100%) of oxygen atoms, carbon atoms, and silicon atoms. It is more preferable that the surface layer part of the gas barrier layer have an oxygen atom content rate of 15 to 65%, a carbon atom content rate of 15 to 65%, and a silicon atom content rate of 10 to 30%. The oxygen atom content, the carbon atom content, and the silicon atom content rate are measured by the method described in the examples.

The area where the oxygen atom content rate gradually decreases and the carbon atom content rate gradually increases from the surface in the depth direction is an area that corresponds to the gas barrier layer. The thickness of the gas barrier layer is normally 5 to 100 nm, and preferably 10 to 50 nm. Examples of the gas barrier layer include a layer obtained by implanting ions into a polyorganosiloxane compound-containing layer (hereinafter may be referred to as "implanted layer"), and a layer obtained by subjecting a polyorganosiloxane compound-containing layer to a plasma treatment.

It is preferable that the surface layer part of the gas barrier layer have a silicon atom 2p electron binding energy peak position determined by X-ray photoelectron spectroscopy (XPS) of 102 to 104 eV.
For example, a polydimethylsiloxane layer has a silicon atom 2p electron binding energy peak position determined by X-ray photoelectron spectroscopy (XPS) of about 101.5 eV. On the other hand, the surface layer part of an ion-implanted layer (gas barrier layer) produced by implanting argon ions into the polydimethylsiloxane layer has a silicon atom 2p electron binding energy peak position determined by X-ray photoelectron spectroscopy (XPS) of about 103 eV. This value is almost equal to that of a known silicon-containing polymer that has a gas barrier capability (e.g., glass or silicon dioxide film) (glass has a silicon atom 2p electron binding energy peak position determined by X-ray photoelectron spectroscopy (XPS) of about 102.5 eV, and a silicon dioxide film has a silicon atom 2p electron binding energy peak position determined by X-ray photoelectron spectroscopy (XPS) of about 103 eV). Specifically, since the laminate according to one embodiment of the invention, in which the surface layer part of the gas barrier layer has a silicon atom 2p electron binding energy peak position of 102 to 104 eV, has a structure identical with or similar to that of glass or a silicon dioxide film, the formed article exhibits an excellent gas barrier capability. The silicon atom 2p electron binding energy peak position is measured by the method described in the examples.

It is preferable that the gas barrier layer included in the laminate according to one embodiment of the invention be formed in the surface area of a polyorganosiloxane compound-containing layer having a thickness of 30 nm to 200 µm, and have a depth of 5 to 100 nm, and more preferably 30 to 50 nm.

The laminate according to one embodiment of the invention may be a laminate that includes a gas barrier layer and a conductor layer, and the gas barrier layer may be produced by implanting ions into a polyorganosiloxane compound-containing layer of a formed body that includes the polyorganosiloxane compound-containing layer in its surface area (i.e., step (I)).

A gas barrier layer that is formed of a material that includes at least an oxygen atom, a carbon atom, and a silicon atom, and has an oxygen atom content rate that gradually decreases from the surface of the gas barrier layer in the depth direction, and has a carbon atom content rate that gradually increases from the surface of the gas barrier layer in the depth direction, can be obtained by implanting ions into the polyorganosiloxane compound-containing layer.

The main chain structure of the polyorganosiloxane compound used for the laminate according to one embodiment of the invention is not particularly limited. The main chain structure of the polyorganosiloxane compound may be linear, ladder-like, or polyhedral.
Examples of the linear main chain structure of the polyorganosiloxane compound include a structure shown by the following formula (a). Examples of the ladder-like main chain structure of the polyorganosiloxane compound include a structure shown by the following formula (b). Examples of the polyhedral main chain structure of the polyorganosiloxane compound include a structure shown by the following formula (c).

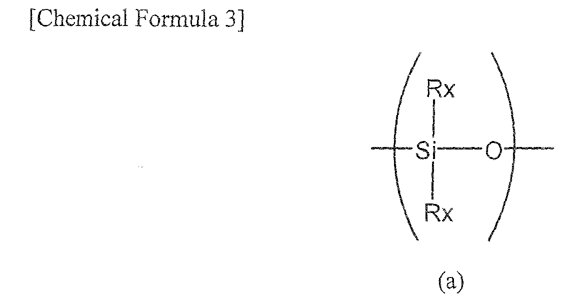

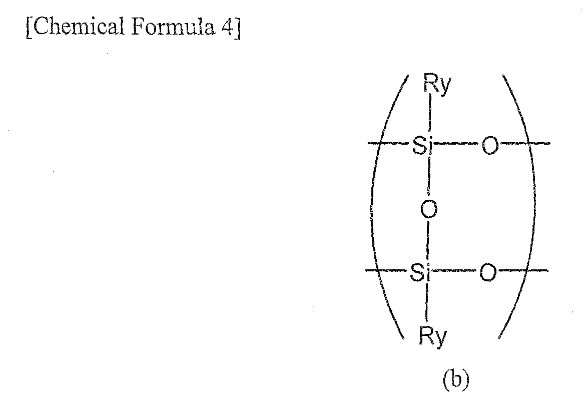

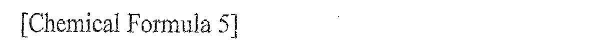

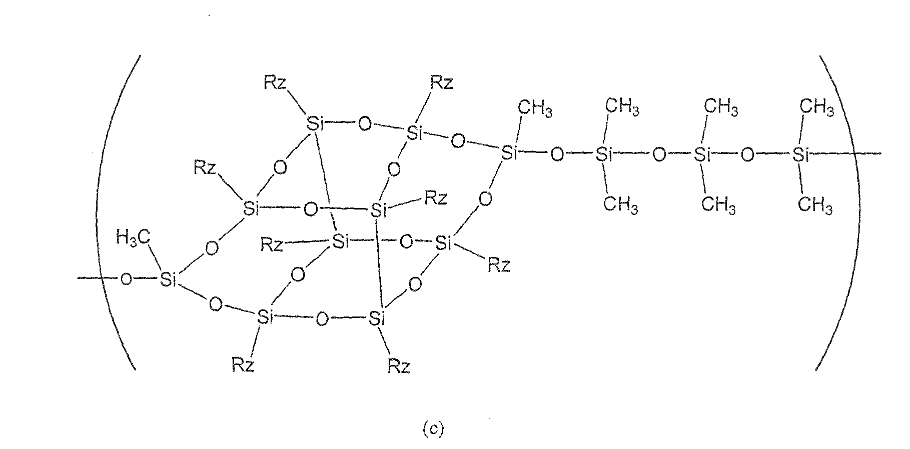

wherein Rx, Ry, and Rz individually represent a hydrogen atom or a non-hydrolyzable group such as a substituted or unsubstituted alkyl group, a substituted or unsubstituted alkenyl group, or a substituted or unsubstituted aryl group. Note that a plurality of Rx in the formula (a), a plurality of Ry in the formula (b), and a plurality of Rz in the formula (c) may respectively be either the same or different, and a case where both Rx in the formula (a) represent a hydrogen atom is excluded.

Examples of the substituted or unsubstituted alkyl group include alkyl groups having 1 to 10 carbon atoms (e.g., methyl group, ethyl group, n-propyl group, isopropyl group, n-butyl group, isobutyl group, sec-butyl group, t-butyl group, n-pentyl group, isopentyl group, neopentyl group, n-hexyl group, n-heptyl group, and n-octyl group).

Examples of the alkenyl group include alkenyl groups having 2 to 10 carbon atoms (e.g., vinyl group, 1-propenyl group, 2-propenyl group, 1-butenyl group, 2-butenyl group, and 3-butenyl group).

Examples of a substituent for the alkyl group and the alkenyl group include halogen, atoms such as a fluorine atom, a chlorine atom, a bromine atom, and an iodine atom; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Examples of the aryl group include aryl groups having 6 to 10 carbon atoms (e.g., phenyl group, 1-naphthyl group, and 2-naphthyl group).

Examples of a substituent for the aryl group include halogen atoms such as a fluorine atom, a chlorine atom, a bromine atom, and an iodine atom; alkyl groups having 1 to 6 carbon atoms, such as a methyl group and an ethyl group; alkoxy groups having 1 to 6 carbon atoms, such as a methoxy group and an ethoxy group; **a** nitro group; a cyano group; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

It is preferable that Rx, Ry, and Rz individually represent a substituted or unsubstituted alkyl group having 1 to 6 carbon atoms or a phenyl group, and particularly preferably a methyl group, an ethyl group, a propyl group, a 3-glycidoxypropyl group, or a phenyl group.

The polyorganosiloxane compound is preferably a linear compound shown by the formula (a) or a ladder-like compound shown by the formula (b), and particularly preferably a linear compound shown by the formula (a) in which Rx represent a methyl group or a phenyl group, or a ladder-like compound shown by the formula (b) in which Ry represent a methyl group, a propyl group, a 3-glycidoxypropyl group, or a phenyl group, from the viewpoint of availability and a capability to form an implanted layer that exhibits an excellent gas barrier capability.

The polyorganosiloxane compound may be produced by a known method that polycondenses a silane compound including a hydrolyzable functional group.

The silane compound may be appropriately selected depending on the structure of the target polyorganosiloxane compound. Specific examples of a preferable silane compound include bifunctional silane compounds such as dimethyldimethoxysilane, dimethyldiethoxysilane, diethyldimethoxysilane, and diethyldiethoxysilane; trifunctional silane compounds such as methyltrimethoxysilane, methyltriethoxysilane, ethyltrimethoxysilane, ethyltriethoxysilane, n-propyltrimethoxysilane, n-butyltriethoxysilane, 3-glycidoxypropyltrimetoxysilane, phenyltrimethoxysilane, phenyltriethoxysilane, and phenyldiethoxymethoxysilane; tetrafunctional silane compounds such as tetramethoxysilane, tetraethoxysilane, tetra-n-propoxysilane, tetraisopropoxysilane, tetra-n-butoxysilane, tetra-t-butoxysilane, tetra-s-butoxysilane, methoxytriethoxysilane, dimethoxydiethoxysilane, and trimethoxyethoxysilane; and the like.

A product commercially available as a release agent, an adhesive, a sealant, a paint, or the like may be used as the polyorganosiloxane compound.

The polyorganosiloxane compound-containing layer may include a component other than a polyorganosiloxane compound insofar as the object of the invention can be achieved. Examples of a component other than the polyorganosiloxane compound include a curing agent, another polymer, an aging preventive, a light stabilizer, a flame retardant, and the like.

The content of the polyorganosiloxane compound in the polyorganosiloxane compound-containing layer is preferably 50 wt% or more, more preferably 70 wt% or more, and particularly preferably 90 wt% or more, from the viewpoint of obtaining an implanted layer that exhibits an excellent gas barrier capability.

The polyorganosiloxane compound-containing layer may be formed by an arbitrary method. For example, the polyorganosiloxane compound-containing layer may be formed by applying a solution that includes at least one polyorganosiloxane compound, an optional component, and a solvent to an appropriate substrate, drying the resulting film, and optionally heating the dried film.

The thickness of the polyorganosiloxane compound-containing layer is not particularly limited, but is normally 30 nm to 200 µm, and preferably 50 nm to 100 µm.

The implanted layer is obtained by implanting ions into the polyorganosiloxane compound-containing layer.
The dose may be appropriately determined depending on the usage of the laminate (e.g., gas barrier capability and transparency), and the like.

Examples of ions implanted include rare gases such as argon, helium, neon, krypton, and xenon; ions of fluorocarbons, hydrogen, nitrogen, oxygen, carbon dioxide, chlorine, fluorine, sulfur, and the like; ions of conductive metals such as gold, silver, copper, platinum, nickel, palladium, chromium, titanium, molybdenum, niobium, tantalum, tungsten, and aluminum; and the like.

Among these, at least one ion selected from the group consisting of ions of hydrogen, oxygen, nitrogen, rare gas, and fluorocarbons is preferable due to ease of implantation and a capability to form an implanted layer that exhibits an excellent gas barrier capability and excellent transparency. It is particularly preferable to use ions of nitrogen, oxygen, argon, or helium.

The ion implantation method is not particularly limited. For example, a method that includes forming a polyorganosiloxane compound-containing layer, and implanting ions into the polyorganosiloxane compound-containing layer may be used.

Ions may be implanted by applying ions (ion beams) accelerated by an electric field, implanting ions present in plasma (plasma ion implantation), or the like. It is preferable to use plasma ion implantation since a gas barrier laminate can be conveniently obtained.

Plasma ion implantation may be implemented by generating plasma in an atmosphere containing a plasma-generating gas (e.g., rare gas), and implanting ions (cations) in the plasma into the surface area of the polyorganosiloxane compound-containing layer by applying a negative high-voltage pulse to the polyorganosiloxane compound-containing layer, for example.

Implantation of ions may be confirmed by subjecting the surface layer part of the gas barrier layer to elemental analysis by X-ray photoelectron spectroscopy (XPS).

### (Conductor layer)

The laminate according to one embodiment of the invention further includes a conductor layer (hereinafter may be referred to as "layer B").
Examples of the material that forms the layer B include a metal, an alloy, a metal oxide, an electrically conductive compound, a mixture thereof, and the like. Specific examples of the material that forms the layer B include conductive metal oxides such as antimony-doped tin oxide (ATO), fluorine-doped tin oxide (FTO), tin oxide, zinc oxide, indium oxide, indium tin oxide (ITO), and indium zinc oxide (IZO); metals such as gold, silver, chromium, and nickel; a mixture of a metal and a conductive metallic oxide; inorganic conductive substances such as copper iodide and copper sulfide; organic conductive materials such as polyaniline, polythiophene, and polypyrrole; and the like. The layer B may be a laminate that includes a plurality of layers formed of these materials.

The layer B may or may not be transparent. A laminate having excellent transparency can be obtained when the layer B is transparent. It is preferable to form the layer B using a conductive metal oxide (particularly preferably ITO) from the viewpoint of transparency.

The layer B may be formed by an arbitrary method. For example, the layer B may be formed by deposition, sputtering, ion plating, thermal CVD, plasma CVD, or the like. It is preferable to form the layer B by sputtering since the layer B can be easily formed.

When forming the layer B by sputtering, a discharge gas (e.g., argon) is introduced into a vacuum chamber. A high-frequency voltage or a direct-current voltage is applied between a target and a substrate (i.e., layer A) to generate plasma, and plasma collides against the target so that the target material adheres to the deposition target to obtain a thin film. The target is formed of the material used to form the layer B.

The thickness of the conductor layer is appropriately selected depending on the application or the like. The thickness of the conductor layer is normally 10 nm to 50 µm, and preferably 20 nm to 20 µm.
The surface resistivity of the conductor layer is normally 1000 Ω/Square or less.

The conductor layer may optionally be patterned. The conductor layer may be patterned by chemical etching (e.g., photolithography), physical etching using a laser or the like, vacuum deposition using a mask, sputtering, a lift-off method, printing, or he like.

### (Laminate)

The laminate according to one embodiment of the invention may include only the layers A and B, or may further include an additional layer other than the layers A and B. The additional layer may be a single layer, or may include a plurality of identical or different layers.

Examples of the additional layer include a base layer, an inorganic compound layer, and the like.
It is preferable that the laminate according to one embodiment of the invention include the base layer from the viewpoint of ease of production, handling, and the like.
A material that forms the base layer may be the same as the material for the base used when forming the polymer compound-containing layer. When the laminate according to one embodiment of the invention includes the base layer, the layer B can be formed via the layer A that exhibits excellent surface smoothness as compared with the base layer by providing the layer A on the base. Therefore, the layer B exhibits excellent surface smoothness.

The laminate according to one embodiment of the invention may further include an inorganic compound layer.
The inorganic compound layer includes one or more inorganic compounds, and exhibits a gas barrier capability.
Examples of the inorganic compound that forms the inorganic compound layer include inorganic compounds that can be deposited under vacuum, and exhibit a gas barrier capability, such as inorganic oxides (e.g., silicon oxide, aluminum oxide, magnesium oxide, indium oxide, calcium oxide, zirconium oxide, titanium oxide, boron oxide, hafnium oxide, and barium oxide), inorganic nitrides (e.g., silicon nitride, aluminum nitride, boron nitride, and magnesium nitride), inorganic carbides (e.g., silicon carbide), inorganic sulfides, composites thereof, and the like. Examples of the composites include inorganic oxynitrides, inorganic oxycarbonates, inorganic carbonitrides, inorganic oxycarbonitrides, and the like.

Among these, it is preferable to use an inorganic oxide, an inorganic nitride, an inorganic oxynitride, an inorganic carbonitride, or an inorganic oxycarbonitride, and more preferably an inorganic nitride.

Examples of the inorganic nitride include metal nitrides shown by the general formula MNy. In the general formula MNy, M represents a metal element, and y is 0.1 to 1.3.

It is preferable to use a silicon nitride (M=silicon), an aluminum nitride (M=aluminum), a titanium nitride (M=titanium), or a tin nitride (M=tin) due to excellent transparency and the like. It is more preferable to use a silicon nitride (M=silicon). The range of y differs depending on M. For example, y=0.1 to 1.3 when M is silicon (Si), y=0.1 to 1.1 when M is aluminum (Al), y=0.1 to 1.3 when M is titanium (Ti), and y=0.1 to 1.3 when M is tin (Sn).

The inorganic compound layer may be formed by an arbitrary method. For example, the inorganic compound layer may be formed by deposition, sputtering, ion plating, thermal CVD, plasma CVD, or the like. Among these, it is preferable to use sputtering, and more preferable to use magnetron sputtering.

The thickness of the inorganic compound layer is normally 10 to 1000 nm, preferably 20 to 500 nm, and more preferably 20 to 100 nm.

The laminate according to one embodiment of the invention preferably has a configuration in which the layers A and B are directly stacked. The expression "the layers A and B are directly stacked" means that the surface of the layer A is directly stacked on the layer B without another layer interposed therebetween. A laminate in which the layers A and B are directly stacked exhibits an excellent gas barrier capability and excellent interlayer adhesion.

When the laminate according to one embodiment of the invention includes the inorganic compound layer, the inorganic compound layer may be provided at an arbitrary position, but is preferably provided between the layers A and B in order to obtain a laminate that exhibits excellent adhesion and an excellent gas barrier capability.

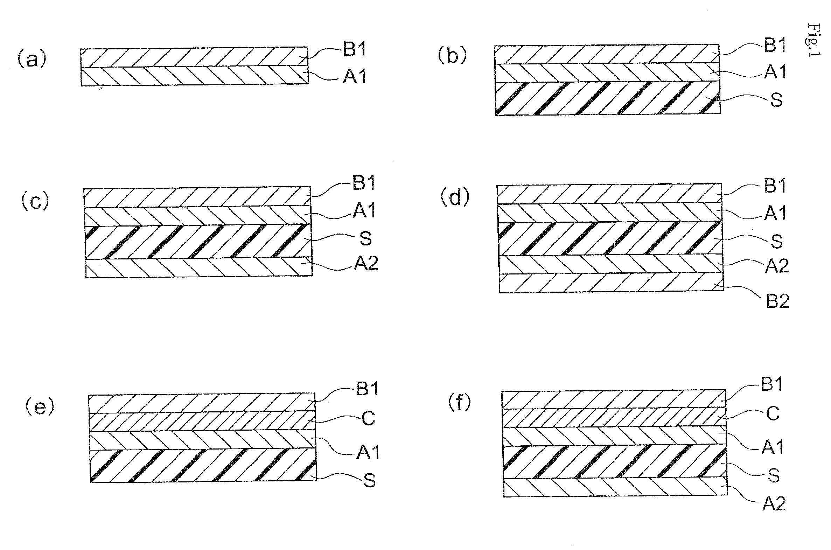

FIG. 1 shows an example of a preferable layer configuration of the laminate according to one embodiment of the invention. Note that the laminate according to one embodiment of the invention is not limited to the example shown in FIG. 1.

In FIG. 1, S indicates the base layer, A1 and A2 indicate the layer A, B1 and B2 indicate the layer B, and C indicates the layer C.
FIG. 1(a) shows a two-layer laminate that includes the layer A and the layer B, FIG. 1(b) shows a three-layer laminate that includes the base layer, the layer A, and the layer B, FIG. 1(c) shows a four-layer laminate that includes the layer A, the base layer, the layer A, and the layer B, FIG. 1(d) shows a five-layer laminate that includes the layer B, the layer A, the base layer, the layer A, and the layer B, FIG 1(e) shows a four-layer laminate that includes the base layer, the layer A, the inorganic compound layer, and the layer B, and FIG. 1(f) shows a five-layer laminate that includes the layer A, the base layer, the layer A, the inorganic compound layer, and the layer B.

The total thickness of the laminate according to one embodiment of the invention may be appropriately determined depending on the application of the resulting electronic device and the like.

### (Production of laminate)

The laminate according to one embodiment of the invention may be produced by an arbitrary method. For example, the laminate according to one embodiment of the invention may be produced by forming the layer A on the base, and forming the layer B on the layer A. According to this method, it is possible to continuously produce a long film-shaped laminate.

A laminate in which the layer A is a gas barrier layer produced using a polyorganosiloxane compound-containing layer may be produced as follows.

Specifically, a polyorganosiloxane compound-containing layer is formed on one side of a long base film. For example, the polyorganosiloxane compound-containing layer may be formed by applying a solution that includes at least one polyorganosiloxane compound, an optional component, and a solvent to one side of the base film using a coating apparatus while transferring the base film in a given direction, drying the resulting film, and optionally heating the resulting film. A knife coater, a gravure coater, or the like may be used as the coating apparatus.

The polymer layer is then subjected to plasma ion implantation using a plasma ion implantation apparatus (γ).

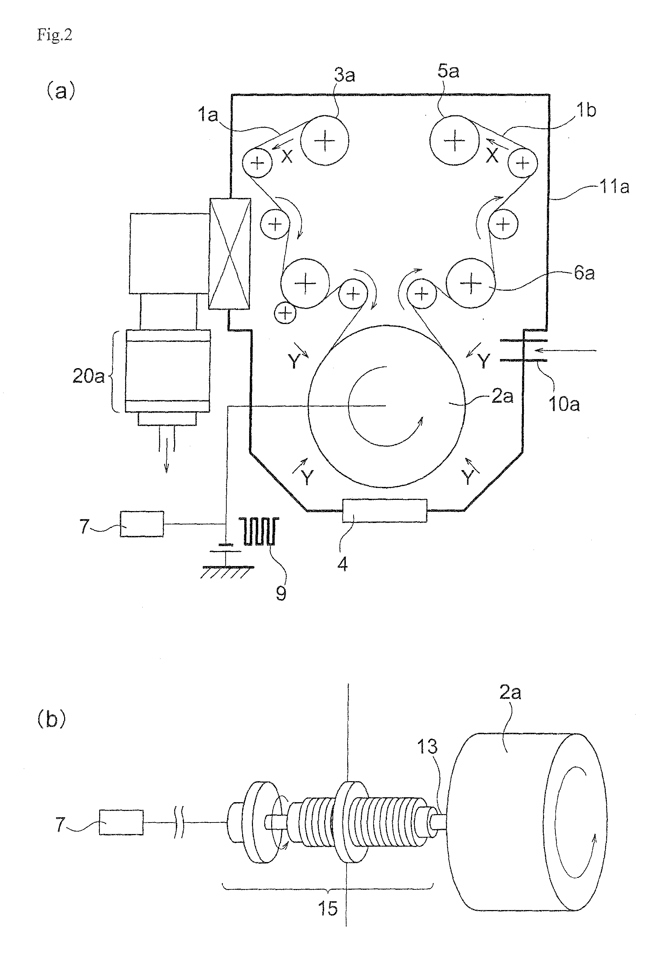

FIG. 2 is a view schematically showing a continuous plasma ion implantation apparatus that includes a plasma ion implantation apparatus.

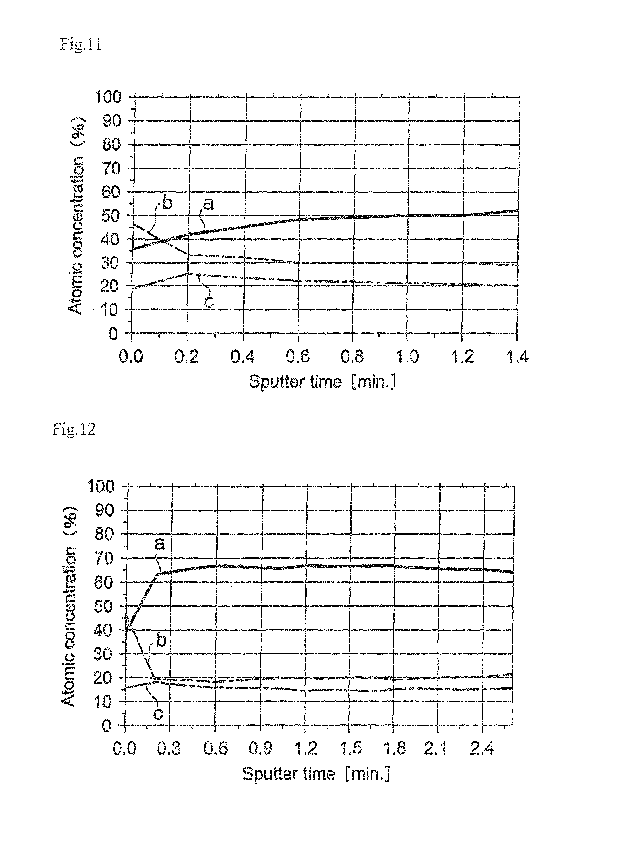

In FIG. 2(a), 11a indicates a chamber, 20a indicates a turbo-molecular pump, 3a indicates a feed roll around which a film 1a is wound before ion implantation, 5a indicates a wind-up roll around which an ion-implanted laminate film 1b is wound, 2a indicates a high-voltage rotary can, 10a indicates a gas inlet, 7 indicates a high-voltage pulse power supply, and 4 indicates a plasma discharge electrode (external electric field). FIG. 2(b) is a perspective view showing the high-voltage rotary can 2a, in which 15 indicates a high-voltage application terminal (feed-through).

In the continuous plasma ion implantation apparatus shown in FIG. 2, the film 1a is transferred from the feed roll 3a in an arrow direction X inside the chamber I 1a, passes through the high-voltage rotary can 2a, and is wound around the wind-up roll 5a. The film 1a may be wound and transferred by an arbitrary method. In one embodiment, the film 1a is transferred by rotating the high-voltage rotary can 2a at a constant speed. The high-voltage rotary can 2a is rotated by rotating a center shaft 13 of the high-voltage application terminal 15 using a motor.

The high-voltage application terminal 15, the transfer rolls 6a that come in contact with the film 1a, and the like are formed of an insulator. For example, the high-voltage application terminal 15, the transfer rolls 6a, and the like are formed by coating the surface of alumina with a resin (e.g., polytetrafluoroethylene). The high-voltage rotary can 2a is formed of a conductor (e.g., stainless steel).

The transfer speed of the film 1a may be appropriately set. The transfer speed of the laminate film 1a is not particularly limited insofar as ions are implanted into the surface area of the film 1a so that the desired implanted layer is formed when the film 1a is transferred from the feed roll 3a and wound around the wind-up roll 5a. The winding speed (line speed) of the film 1b is determined depending on the applied voltage, the size of the apparatus, and the like, but is normally 0.1 to 2 m/min, and preferably 0.2 to 0.7 m/min.

The pressure inside the chamber 11a is reduced by discharging air from the chamber 11a using the turbo-molecular pump 20a connected to a rotary pump. The degree of decompression is normally 1×10⁻⁴ to 1 Pa, and preferably 1×10⁻³ to 1×10⁻² Pa.

An ion implantation gas is introduced into the chamber 11a through the gas inlet 10a so that the chamber 11a is filled with the ion implantation gas under reduced pressure. The ion implantation gas also serves as a plasma-generating gas.

Plasma is then generated using the plasma discharge electrode 4 (external electric field). The plasma may be generated using a known method (e.g., microwave or RF high-frequency electric power supply).

A negative high-voltage pulse 9 is applied from the high-voltage pulse power supply 7 connected to the high-voltage rotary can 2a through the high-voltage application terminal 15. When the negative high-voltage pulse is applied to the high-voltage rotary can 2a, ions present in the plasma are attracted, and implanted into the surface of the film 1a around the high-voltage rotary can 2a (arrow Y in FIG. 2(a)). A laminate film 1b in which the layer A is formed on the base layer is thus obtained.

A layer B is then formed by sputtering on the layer A of the laminate film 1b (i.e., the side where the ion-implanted layer is formed).

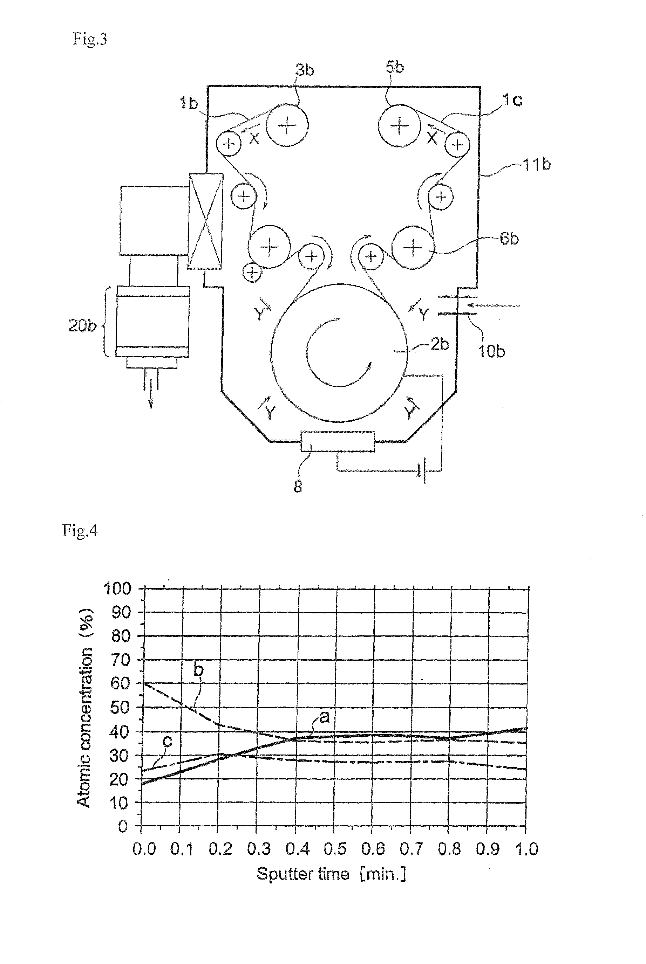

The layer B may be formed using a continuous sputtering apparatus shown in FIG. 3, for example.
In the continuous sputtering apparatus shown in FIG. 3, 11b indicates a chamber, 20b indicates a turbo-molecular pump, 3b indicates a feed roll that feeds the laminate film 1b, 5b indicates a wind-up roll around which a film 1c including the layer B is wound, 6b indicates a transfer roll, and 10b indicates a gas inlet. 2b indicates a rotary can, and 8 indicates a sputtering target.

The laminate film 1b is transferred from the feed roll 3b in an arrow direction X by rotating the rotary can 2b, and wound around the wind-up roll 5b.

The film 1b is placed in the chamber 11b so that the layer B is formed on the layer A, and air is discharged from the chamber 11b (i.e., the pressure inside the chamber 11b is reduced) using the turbo-molecular pump 20b connected to a rotary pump, in the same manner as the plasma ion implantation apparatus shown in FIG. 2.

High-frequency power is then applied to the target while introducing argon gas and oxygen gas into the chamber 11b through the gas inlet 10b, so that a plasma discharge occurs. The argon gas and the oxygen gas are thus ionized, and collide against the target. ITO and the like that form the target are released as sputter particles due to the impact, and are deposited on the surface of the layer A of the laminate film 1b.

The laminate film 1c (laminate according to one embodiment of the invention) in which the layer B is formed on the layer A of the laminate film 1b is thus obtained.

A laminate in which an inorganic compound layer is formed on the layer A, and the layer B is formed on the inorganic compound layer, may be obtained by forming an inorganic compound layer on the layer A of the laminate film 1b (i.e., side where the ion-implanted layer is formed) using a magnetron sputtering apparatus, and forming the layer B on the inorganic compound layer, for example.

In this case, when the laminate film 1b is a long film, the inorganic compound layer may be formed using a magnetron sputtering apparatus while transferring the laminate film 1b in a given direction, and the layer B may be continuously formed on the surface of the inorganic compound layer while transferring the laminate film in a given direction.
The above laminate (see (1) to (7)) can be easily produced by the above method.

The laminate according to one embodiment of the invention thus obtained exhibits an excellent gas barrier capability and excellent adhesion. The laminate according to one embodiment of the invention exhibits an excellent gas barrier capability since the laminate has low gas (e.g., water vapor) permeability. The water vapor permeability of the laminate according to one embodiment of the invention is preferably 1.0 g/(m²·day) or less, more preferably 0.6 g/(m²·day) or less, and still more preferably 0.1 g/(m²·day) or less. The gas (e.g., water vapor) permeability of the laminate may be measured using a known gas permeability measuring apparatus.

The interlayer adhesion of the laminate according to one embodiment of the invention may be evaluated by subjecting the laminate to a test that attaches and peels off an adhesive tape in accordance with JIS H 8504.

The conductor layer of the laminate according to one embodiment of the invention exhibits excellent surface smoothness. The surface roughness (Ra) of the conductor layer of the laminate according to one embodiment of the invention is normally 2.0 nm or less, preferably 1.5 nm or less, and more preferably 0.5 nm or less. The surface roughness of the conductor layer may be measured using an atomic force microscope (AFM).

### 2) Electronic device member and electronic device

An electronic device member according to one embodiment of the invention includes the laminate according to one embodiment of the invention. Therefore, the electronic device member according to one embodiment of the invention exhibits conductivity, an excellent gas barrier capability, excellent interlayer adhesion, flexibility, transparence, and a reduced weight. Accordingly, the electronic device member may suitably be used as a member (e.g., electrode substrate) of a display (e.g., liquid crystal display or EL display), a solar battery, or the like.

An electronic device according to one embodiment of the invention includes the electronic device member according to one embodiment of the invention. Specific examples of the electronic device include a liquid crystal display, an organic EL display, an inorganic EL display, electronic paper, a solar cell, and the like.
Since the electronic device according to one embodiment of the invention includes the electronic device member that includes the laminate according to one embodiment of the invention, the electronic device exhibits an excellent gas barrier capability.

### EXAMPLES

The invention is further described below by way of examples. Note that the invention is not limited to the following examples.

A plasma ion implantation apparatus, an X-ray photoelectron spectroscopy (XPS) measuring device, X-ray photoelectron spectroscopy (XPS) measurement conditions, a conductor layer surface roughness (Ra) measurement method, a water vapor permeability measuring apparatus, water vapor permeability measurement conditions, a conductor layer surface resistivity measuring apparatus, a visible light transmittance measuring apparatus, and an adhesion test method used in the examples are as follows. An apparatus that implants ions using an external electric field was used as the plasma ion implantation apparatus.

### (Plasma ion implantation apparatus)

RF power supply: "RF56000" manufactured by JEOL Ltd.
High-voltage pulse power supply: "PV-3-HSHV-0835" manufactured by Kurita Seisakusho Co., Ltd.

### (X-ray photoelectron spectroscopy measuring apparatus)

Measuring apparatus: "PHI Quantera SXM" manufactured by ULVAC-PHI, Incorporated
X-ray beam diameter: 100 µm
Electric power: 25 W
Voltage: 15 kV
Take-off angle: 45°

The following measurements were performed under the above measurement conditions.

### Measurement of oxygen atom content rate, carbon atom content rate, silicon atom content rate, and silicon atom 2p electron binding energy peak position

The oxygen atom content rate, the carbon atom content rate, the silicon atom content rate, and the silicon atom 2p electron binding energy peak position in the surface of the formed articles of Examples 1 to 15 subjected to plasma ion implantation, and the surface of the polydimethylsiloxane-containing layer of the formed article of Comparative Example 1 were measured. The plasma ion-implanted surface (Examples 1 to 15) or the surface of the polydimethylsiloxane-containing layer (Comparative Example 1) of each formed article was subjected to sputtering using argon gas in the depth direction, and the oxygen atom content rate, the carbon atom content rate, and the silicon atom content rate in the surface exposed by sputtering were measured. This operation was repeated to measure the oxygen atom content rate, the carbon atom content rate, the silicon atom content rate, and the silicon atom 2p electron binding energy peak position.

The applied voltage during sputtering using argon gas was -4 kV. The sputtering time per once was 12 seconds. The sputtering rate was 100 nm/min (Examples 1 to 6 and 11 to 15 and Comparative Example 1), 70 nm/min (Examples 7 and 8), or 30 nm/min (Examples 9 and 10).

### (Measurement of surface roughness of conductor layer)

The surface roughness of the conductor layer was measured using an atomic force microscope (AFM) ("SPA300HV" manufactured by SII NanoTechnology Inc.).

### (Adhesion test)

A cross-cut test (i.e., an adhesive tape was peeled off) was performed in accordance with JIS H 8504. The layer B was cut so that a 2×2 mm square was formed. The shape of the layer B was observed with the naked eye, and evaluated (six grades) in accordance with JIS K 5600-5-6 (see Table 1).

### (Measurement of water vapor permeability)

The water vapor permeability was measured using a permeability tester ("L80-5000" manufactured by LYSSY) at a temperature of 40°C and relative humidity of 90%.

### (Measurement of surface resistivity of conductor layer)

The surface resistivity of the conductor layer was measured using a surface resistivity meter ("Loresta GP" manufactured by Mitsubishi Chemical Corp.).

### (Measurement of visible light transmittance)

The visible light transmittance (total light transmittance) was measured using a haze meter ("NDH2000" manufactured by Nippon Denshoku Industries Co., Ltd.). The beam incident surface of the formed article was the ion-implanted surface (Examples 1 to 15), or the surface of the polydimethylsiloxane-containing layer (Comparative Example 1).

### Example 1

A silicone resin (A) (silicone release agent "KS835" manufactured by Shin-Etsu Chemical Co., Ltd.) containing a polydimethylsiloxane as the main component (polyorganosiloxane compound) was applied to a polyethylene terephthalate film (PET film) ("PET38T-300" manufactured by Toray Industries Inc., thickness: 38 µm) (substrate) using a Meyer bar. The silicone resin (A) was heated at 120°C for 2 minutes to form a layer including the silicone release agent A (thickness: 100 nm). A formed body was thus obtained. Nitrogen ions were implanted into the surface of the polydimethylsiloxane-containing layer using the plasma ion implantation apparatus shown in FIG. 2 to obtain a formed article 1.

The following plasma ion implantation conditions were used.
Plasma-generating gas: N₂
Duty ratio: 0.5%
Repetition frequency: 1000 Hz
Applied voltage: -10 kV
RF power supply: frequency: 13.56 MHz, applied electric power: 1000 W
Chamber internal pressure: 0.2 Pa
Pulse width: 5 µs
Processing time (ion implantation time): 5 minutes
Transfer speed: 0.4 m/min

An ITO film (thickness: 50 nm) (conductor layer) was formed by magnetron sputtering on the ion-implanted polyorganosiloxane compound layer of the formed article 1 to obtain a laminate 1 (base layer (PET film) - layer A (nitrogen ion-implanted polyorganosiloxane compound layer) - layer B (ITO film)).

The following sputtering conditions were used.
Plasma-generating gas: argon and oxygen
Gas flow rate: argon: 100 sccm, oxygen: 5 sccm
Electric power: 1500 W
Chamber internal pressure: 0.2 Pa
Line speed: 0.2 m/min
Sputtering target: ITO

### Example 2

A formed article 2 was obtained in the same manner as in Example 1, except for using argon (Ar) as the plasma-generating gas.
An ITO film (thickness: 50 nm) (conductor layer) was formed by magnetron sputtering on the ion-implanted polyorganosiloxane compound layer of the formed article 2 in the same manner as in Example 1 to obtain a laminate 2 (base layer (PET film) - layer A (argon ion-implanted polyorganosiloxane compound layer) - layer B (ITO film)).

### Example 3

A formed article 3 was obtained in the same manner as in Example 1, except for using helium (He) as the plasma-generating gas.
An ITO film (thickness: 50 nm) (conductor layer) was formed by magnetron sputtering on the ion-implanted polyorganosiloxane compound layer of the formed article 3 in the same manner as in Example 1 to obtain a laminate 3 (base layer (PET film) - layer A (helium ion-implanted polyorganosiloxane compound layer) - layer B (ITO film)).

### Example 4

A formed article 4 was obtained in the same manner as in Example 1, except for using oxygen (O₂) as the plasma-generating gas.
An ITO film (thickness: 50 nm) (conductor layer) was formed by magnetron sputtering on the ion-implanted polyorganosiloxane compound layer of the formed article 4 in the same manner as in Example 1 to obtain a laminate 4 (base layer (PET film) - layer A (oxygen ion-implanted polyorganosiloxane compound layer) - layer B (ITO film)).

### Example 5

A silicone resin (B) containing a polyorganosiloxane compound as the main component and having a structure in which some of the methyl groups of polydimethylsiloxane were substituted with a phenyl group ("X62-9201B" manufactured by Shin-Etsu Chemical Co., Ltd.) was applied to a PET film ("PET38T-300" manufactured by Toray Industries Inc.) using a Meyer bar. The silicone resin (B) was heated at 120°C for 2 minutes to obtain a layer including a polyorganosiloxane including a phenyl group (thickness: 100 nm). A formed body was thus obtained. Nitrogen ions were implanted into the surface of the layer including the silicone resin (B) in the same manner as in Example 1 to obtain a formed article 5.
An ITO film (thickness: 50 nm) (conductor layer) was formed by magnetron sputtering on the ion-implanted polyorganosiloxane compound layer of the formed article 5 in the same manner as in Example 1 to obtain a laminate 5 (base layer (PET film) - layer A (nitrogen ion-implanted polyorganosiloxane compound layer) - layer B (ITO film)).

### Example 6

A formed article 6 was obtained in the same manner as in Example 5, except for using argon (Ar) as the plasma-generating gas.
An ITO film (thickness: 50 nm) (conductor layer) was formed by magnetron sputtering on the ion-implanted polyorganosiloxane compound layer of the formed article 6 in the same manner as in Example 1 to obtain a laminate 6 (base layer (PET film) - layer A (argon ion-implanted polyorganosiloxane compound layer) - layer B (ITO film)).

### Example 7

3.29 g (20 mmol) of n-propyltrimethoxysilane (manufactured by Tokyo Chemical Industry Co., Ltd.), 4.73 g (20 mmol) of 3-glycidoxypropyltrimethoxysilane (manufactured by Tokyo Chemical Industry Co., Ltd.), 20 ml of toluene, 10 ml of distilled water, and 0.10 g (1 mmol) of phosphoric acid (manufactured by Kanto Chemical Co., Ltd.) were mixed, and reacted at room temperature for 24 hours. After completion of the reaction, a saturated aqueous solution of sodium hydrogen carbonate was added to the reaction mixture. After the addition of 100 ml of ethyl acetate, the organic layer was isolated. The organic layer was then washed twice with distilled water and dried over anhydrous magnesium sulfate, and magnesium sulfate was separated by filtration. The filtrate was added dropwise to a large quantity of n-hexane to effect precipitation. After separating n-hexane by decantation, the precipitate was dissolved in tetrahydrofuran (THF), and the solution was collected. After evaporating THF from the THF solution under reduced pressure using an evaporator, the residue was dried under vacuum to obtain polysilsesquioxane (polyorganosiloxane compound) having a ladder-like structure. The weight average molecular weight of the polysilsesquioxane was 2000.

A solution (solid content: 2 mass%) obtained by dissolving the polysilsesquioxane in toluene was applied to a PET film ("PET38T-300" manufactured by Toray Industries Inc.) using a Meyer bar. The polysilsesquioxane was cured at 125°C for 6 hours to obtain a formed body including a polysilsesquioxane layer (thickness: 100 nm). Nitrogen ions were implanted into the surface of the cured silsesquioxane layer in the same manner as in Example 1 to obtain a formed article 7. Note that the weight average molecular weight refers to a polystyrene-reduced weight average molecular weight measured by gel permeation chromatography (GPC). The water vapor permeability and the total light transmittance of the formed body before plasma ion implantation were 12.1 g/(m²·day) and 89.10%, respectively.

An ITO film (thickness: 50 nm) (conductor layer) was formed by magnetron sputtering on the ion-implanted polyorganosiloxane compound layer of the formed article 7 in the same manner as in Example 1 to obtain a laminate 7 (base layer (PET film) - layer A (nitrogen ion-implanted polyorganosiloxane compound layer) - layer B (ITO film)).

### Example 8

A formed article 8 was obtained in the same manner as in Example 7, except for using argon (Ar) as the plasma-generating gas.
An ITO film (thickness: 50 nm) (conductor layer) was formed by magnetron sputtering on the ion-implanted polyorganosiloxane compound layer of the formed article 8 in the same manner as in Example 1 to obtain a laminate 8 (base layer (PET film) - layer A (argon ion-implanted polyorganosiloxane compound layer) - layer B (ITO film)).

### Example 9

7.94 g (40 mmol) of phenyltrimethoxysilane (manufactured by Tokyo Chemical Industry Co., Ltd.), 20 ml of toluene, 10 ml of distilled water, and 0.10 g (1 mmol) of phosphoric acid (manufactured by Kanto Chemical Co., Ltd.) were mixed, and reacted at room temperature for 24 hours. After completion of the reaction, a saturated aqueous solution of sodium hydrogen carbonate was added to the reaction mixture. After the addition of 100 ml of ethyl acetate, the organic layer was isolated. The organic layer was then washed twice with distilled water and dried over anhydrous magnesium sulfate, and magnesium sulfate was separated by filtration. The filtrate was added dropwise to a large quantity of n-hexane to effect precipitation. After separating n-hexane by decantation, the precipitate was dissolved in THF, and the solution was collected. After evaporating THF under reduced pressure using an evaporator, the residue was dried under vacuum to obtain polysilsesquioxane (polyorganosiloxane compound) having a ladder-like structure. The weight average molecular weight of the polysilsesquioxane was 1600. A solution (solid content: 2 mass%) prepared by dissolving the polysilsesquioxane in toluene was applied to a PET film ("PET38T-300" manufactured by Toray Industries Inc.) using a Meyer bar. The polysilsesquioxane was cured at 125°C for 6 hours to obtain a formed body including a polysilsesquioxane layer (thickness: 100 nm). Nitrogen ions were implanted into the surface of the cured polysilsesquioxane layer in the same manner as in Example 1 to obtain a formed article 9. The water vapor permeability and the total light transmittance of the formed body before plasma ion implantation were 11.7 g/(m²·day) and 86.05%, respectively.

An ITO film (thickness: 50 nm) (conductor layer) was formed by magnetron sputtering on the ion-implanted polyorganosiloxane compound layer of the formed article 9 in the same manner as in Example 1 to obtain a laminate 9 (base layer (PET film) - layer A (nitrogen ion-implanted polyorganosiloxane compound layer) - layer B (ITO film)).

### Example 10

A formed article 10 was obtained in the same manner as in Example 9, except for using argon (Ar) as the plasma-generating gas.
An ITO film (thickness: 50 nm) (conductor layer) was formed by magnetron sputtering on the ion-implanted polyorganosiloxane compound layer of the formed article 10 in the same manner as in Example 1 to obtain a laminate 10 (base layer (PET film) - layer A (argon ion-implanted polyorganosiloxane compound layer) - layer B (ITO film)).

### Example 11

A polyorganosiloxane compound ("KS835" manufactured by Shin-Etsu Chemical Co., Ltd., silicone resin containing polydimethylsiloxane as the main component) was applied to a polyethylene terephthalate film (PET film) ("PET38T-300" manufactured by Mitsubishi Plastics, Inc., thickness: 38 µm). The resulting film was heated at 120°C for 2 minutes to form a polydimethylsiloxane-containing layer (thickness: 100 nm) on the PET film. Argon ions were then implanted into the surface of the polyorganosiloxane compound layer using a plasma ion implantation apparatus.

The following ion implantation conditions were used.
Plasma-generating gas: argon
Duty ratio: 1%
Repetition frequency: 1000 Hz
Applied voltage: -10 kV
RF power supply: frequency: 13.56 MHz, applied electric power: 1000 W
Chamber internal pressure: 0.2 Pa
Pulse width: 5 µs
Processing time: 5 minutes
Line speed: 0.2 m/min

An ITO film (thickness: 50 nm) (conductor layer) was formed by magnetron sputtering on the ion-implanted polyorganosiloxane compound layer in the same manner as in Example 1 to obtain a laminate 11 (base layer (PET film) - layer A (argon ion-implanted polyorganosiloxane compound layer) - layer B (ITO film)).

The following sputtering conditions were used.
Plasma-generating gas: argon and oxygen
Gas flow rate: argon: 100 sccm, oxygen: 5 sccm
Electric power: 1500 W
Chamber internal pressure: 0.2 Pa
Line speed: 0.2 m/min
Sputtering target: ITO

### Example 12

A laminate 12 (base layer (PET film) - layer A (nitrogen ion-implanted polyorganosiloxane compound layer) - layer B (ITO film)) was produced in the same manner as in Example 11, except for using nitrogen as the plasma-generating gas.

### Example 13

A polyorganosiloxane compound layer was formed in the same manner as in Example 11 on the side of the PET film of the laminate 11 obtained in Example 11 where the polyorganosiloxane compound layer was not formed, and the polyorganosiloxane compound layer subjected to ion implantation in the same manner as in Example 11 to obtain a laminate 13 (layer A (argon ion-implanted polyorganosiloxane compound layer) - base layer (PET film) - layer A (argon ion-implanted polyorganosiloxane compound layer) - layer B (ITO film)).

### Example 14

The same operation as in Example 11 was performed, except that aluminum was used as the sputtering target, and argon (100 sccm) was used as the plasma-generating gas. Specifically, an aluminum film (thickness: 50 nm) was formed instead of the ITO film to obtain a laminate 14 (base layer (PET film) - layer A (argon ion-implanted polyorganosiloxane compound layer) - layer B (aluminum film)).

### Example 15

A polyorganosiloxane compound layer was formed on a PET film in the same manner as in Example 11, and argon ions were implanted into the surface of the polyorganosiloxane compound layer. A silicon nitride film (thickness: 50 nm) (inorganic compound layer) was formed by magnetron sputtering on the ion-implanted polyorganosiloxane compound layer. The following sputtering conditions were used.

### Plasma-generating gas: argon and nitrogen

Gas flow rate: argon: 100 sccm, nitrogen: 60 sccm
Electric power: 2500 W
Chamber internal pressure: 0.2 Pa
Line speed: 0.2 m/min
Sputtering target: Si

An ITO film (thickness: 50 nm) was formed by magnetron sputtering on the silicon nitride film in the same manner as in Example 11 to obtain a laminate 15 (base layer (PET film) - layer A (argon ion-implanted polyorganosiloxane compound layer) - inorganic compound layer - layer B (ITO film)).

### Comparative Example 1

A formed article was obtained in the same manner as in Example 1, except that ion implantation was not performed. Specifically, the polydimethylsiloxane-containing layer was formed on the PET film to obtain a formed article 16. An ITO film (thickness: 50 nm) (conductor layer) was formed by magnetron sputtering to obtain a laminate 16 (base layer (PET film) - polyorganosiloxane-containing - layer B (ITO film)).

### Comparative Example 2

An ITO film (thickness,: 50 nm) (conductor layer) was formed by magnetron sputtering on the PET film used in Example 11 to obtain a laminate 17 (base layer (PET film) - layer B (ITO film)). The sputtering conditions were the same as those of Example 11.

### Comparative Example 3

The same operation as in Example 11 was performed, except that a silicon nitride film (thickness: 50 nm) was formed by magnetron sputtering on the PET film instead of forming the polyorganosiloxane compound layer to obtain a laminate 18 (base layer (PET film) - inorganic compound layer (silicon nitride film) - layer B (ITO film)). The following sputtering conditions were used when forming the silicon nitride film.

Plasma-generating gas: argon and nitrogen
Gas flow rate: argon: 100 sccm, nitrogen: 60 sccm
Electric power: 2500 W
Chamber internal pressure: 0.2 Pa
Line speed: 0.2 m/min
Sputtering target: Si

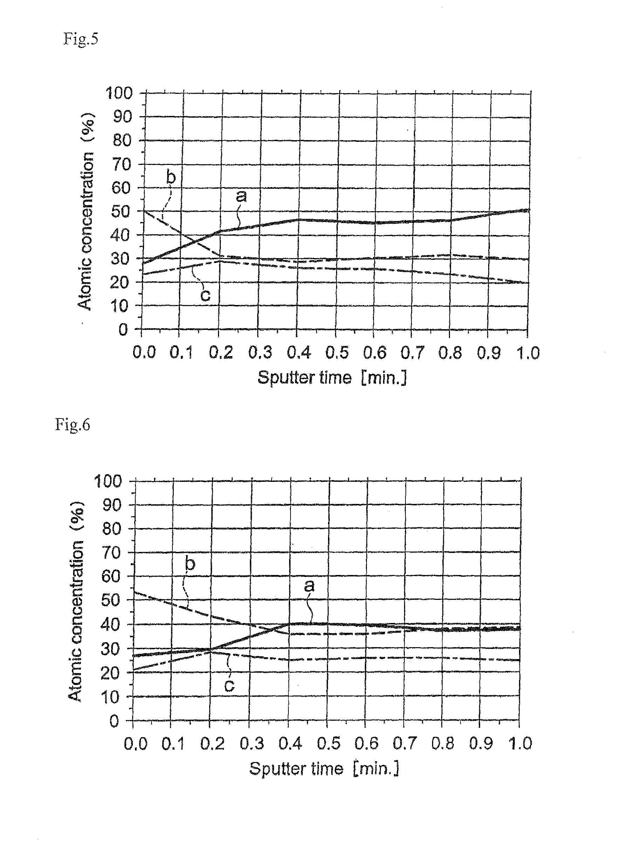

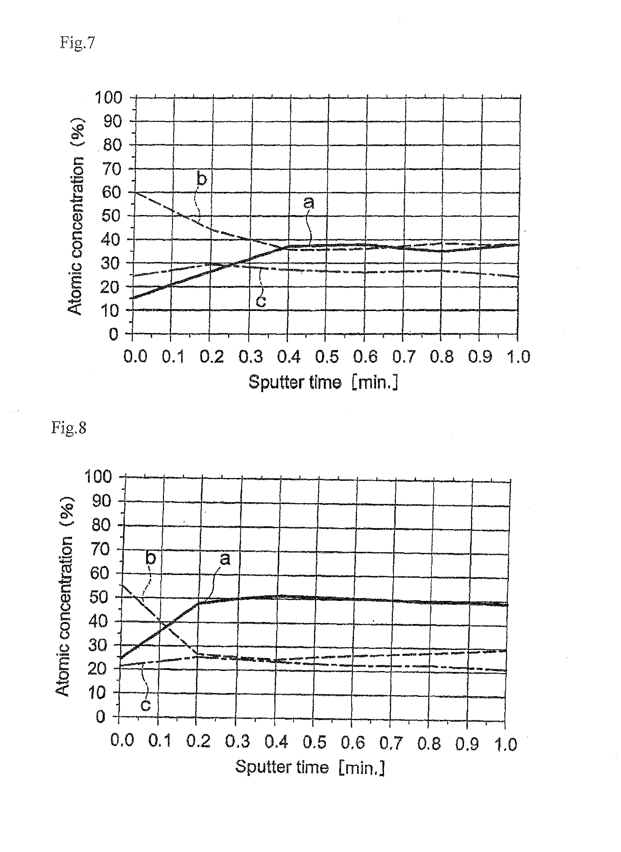

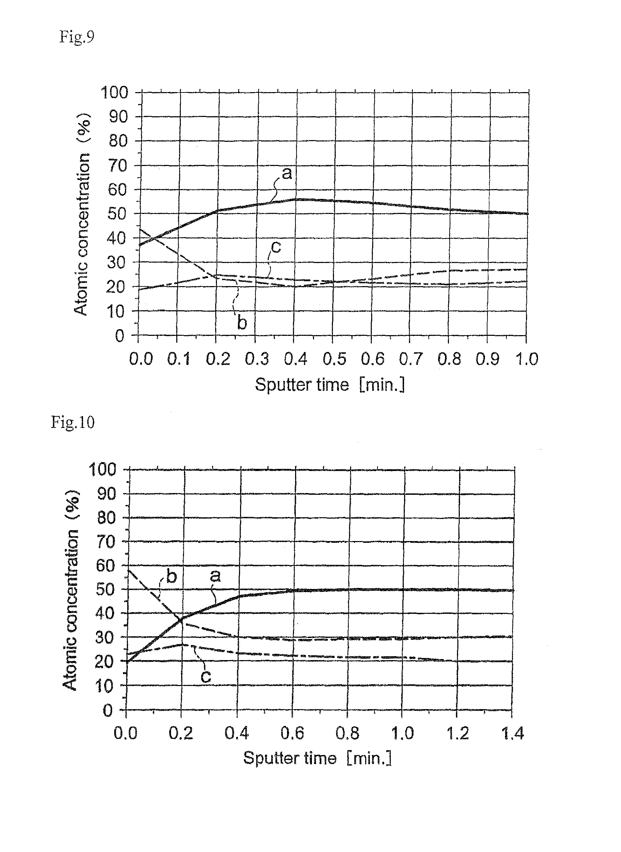

FIGS. 4 to 14 show the XPS elemental analysis results for the oxygen atom content rate, the carbon atom content rate, and the silicon atom content rate of the formed articles 1 to 10 and 16 of Examples 1 to 10 and Comparative Example 1.

In FIGS. 4 to 14, the vertical axis indicates the oxygen atom content rate (%), the carbon atom content rate (%), and the silicon atom content rate (%) based on the total content (=100%) of oxygen atoms, carbon atoms, and silicon atoms, and the horizontal axis indicates the cumulative sputtering time (Sputter time (min)). Since the sputtering rate was constant, the cumulative sputtering time (Sputter time) corresponds to the depth. In FIGS. 4 to 14, a indicates the carbon atom content rate, b indicates the oxygen atom content rate, and c indicates the silicon atom content rate.

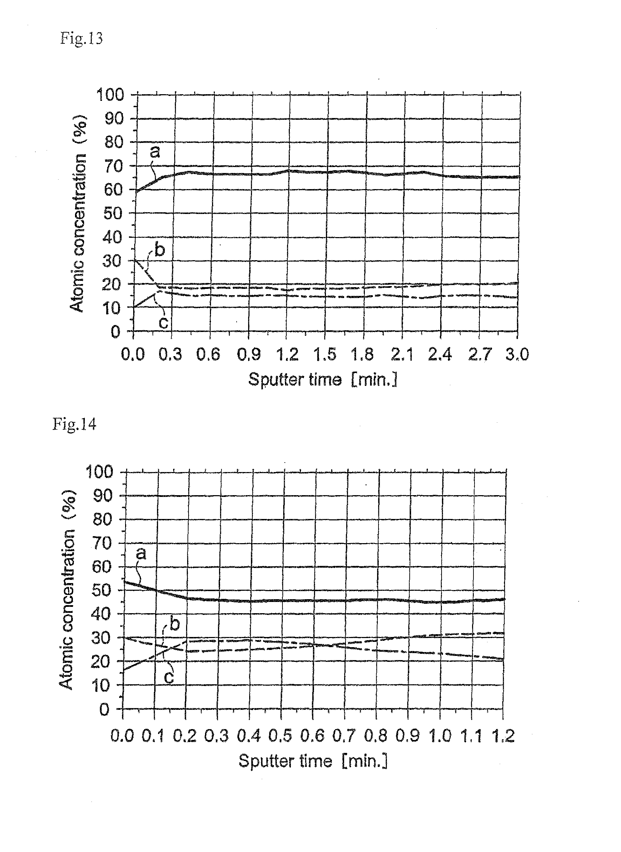

As shown in FIGS. 4 to 13, it was confirmed that the formed articles 1 to 10 had an area (gas barrier layer) where the oxygen atom content rate gradually decreases and the carbon atom content rate gradually increases from the surface in the depth direction. As shown in FIG. 14, the formed article 16 of Comparative Example 1 did not have the above area.
It was also confirmed that the formed articles 11 to 15 had an area (gas barrier layer) where the oxygen atom content rate gradually decreases and the carbon atom content rate gradually increases from the surface in the depth direction same as the formed articles 1 to 10.

Table 1 shows the measurement results for the oxygen atom content rate, the carbon atom content rate, the silicon atom content rate, and the silicon atom 2p electron binding energy peak position in the surface layer part of the gas barrier layer (i.e., an area where the oxygen atom content rate gradually decreases and the carbon atom content rate gradually increases from the surface in the depth direction) of the formed articles of Examples 1 to 10.

Note that the surface of the gas barrier layer of the formed articles of Examples 1 to 10 is the plasma ion-implanted surface. Therefore, the values measured for the plasma ion-implanted surface correspond to the oxygen atom content rate, the carbon atom content rate, the silicon atom content rate, and the silicon atom 2p electron binding energy peak position in the surface layer part of the gas barrier layer.
The oxygen atom content rate, the carbon atom content rate, and the silicon atom content rate were calculated from the peak area of each atom with respect to the total peak area (=100%) of an oxygen atom, a carbon atom, and a silicon atom.

**TABLE 1**

| | Formed article | Content rate | | | Peak position (eV) |
|---|---|---|---|---|---|
| | | Oxygen atom (%) | Carbon atom (%) | Silicon atom (%) | |
| Example 1 | 1 | 59.6 | 17.5 | 22.9 | 103.0 |
| Example 2 | 2 | 49.7 | 27.3 | 22.9 | 103.3 |
| Example 3 | 3 | 52.9 | 26.5 | 20.6 | 103.1 |
| Example 4 | 4 | 60.3 | 15.3 | 24.5 | 103.1 |
| Example 5 | 5 | 54.5 | 24.3 | 21.2 | 103.1 |
| Example 6 | 6 | 44.0 | 37.4 | 18.7 | 103.0 |
| Example 7 | 7 | 58.1 | 19.3 | 22.6 | 103.0 |
| Example 8 | 8 | 46.3 | 35.4 | 18.3 | 103.0 |
| Example 9 | 9 | 46.0 | 38.8 | 15.2 | 102.9 |
| Example 10 | 10 | 30.8 | 58.9 | 10.3 | 102.9 |

As shown in Table 1, the surface of the gas barrier layer of the formed articles 1 to 10 had a silicon atom 2p electron binding energy peak position of 102.9 to 103.3 eV.

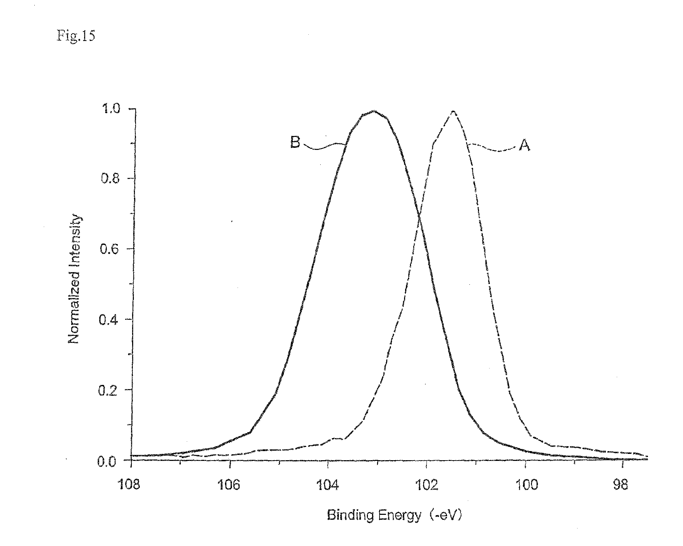

FIG. 15 shows the XPS analysis results for the silicon atom 2p electron binding energy of the formed article 2 of Example 2. In FIG. 15, the vertical axis indicates the peak intensity, and the horizontal axis indicates the binding energy (eV). As shown in FIG. 15, the formed article 2 had a silicon atom 2p electron binding energy peak position (B) of 103.3 eV. The silicon atom 2p electron binding energy peak position of the formed article 2 was 101.5 eV before ion implantation (corresponding to A (Comparative Example 1)), and shifted to the high energy side (103.3 eV).

The surface roughness Ra (nm), the water vapor permeability, the surface resistivity, and the visible light transmittance of the laminates 1 to 18 of Examples 1 to 15 and Comparative Examples 1 to 3 were measured, and the formed articles 1 to 18 were subjected to an adhesion test. The measurement results and the evaluation results are shown in Table 2.

**TABLE 2**

| | Laminate | Ra (nm) | Water vapor permeability (g/(m²·day)) | Surface resistivity (Ω/square) | Visible light transmittance (%) | Adhesion (good: 0 ∼ bad: 5) |
|---|---|---|---|---|---|---|
| Example 1 | 1 | 0.31 | 0.08 | 83.5 | 74.6 | 0 |
| Example 2 | 2 | 0.28 | 0.06 | 82.8 | 75.1 | 0 |
| Example 3 | 3 | 0.33 | 0.51 | 81.4 | 78.1 | 0 |
| Example 4 | 4 | 0.25 | 0.09 | 82.1 | 79.2 | 0 |
| Example 5 | 5 | 0.41 | 0.28 | 81.1 | 81.5 | 0 |
| Example 6 | 6 | 0.38 | 0.21 | 83.2 | 80.3 | 0 |
| Example 7 | 7 | 0.29 | 0.12 | 83.4 | 83.1 | 0 |
| Example 8 | 8 | 0.31 | <0.01 | 83.2 | 83.2 | 0 |
| Example 9 | 9 | 0.42 | <0.01 | 81.1 | 79.8 | 0 |
| Example 10 | 10 | 0.30 | <0.01 | 81.5 | 78.2 | 0 |
| Example 11 | 11 | 0.26 | 0.06 | 82.7 | 75.0 | 0 |
| Example 12 | 12 | 0.32 | 0.08 | 83.5 | 74.6 | 0 |
| Example 13 | 13 | 0.30 | <0.01 | 83.7 | 68.9 | 0 |
| Example 14 | 14 | 0.43 | 0.02 | 5.5 | 0 | 0 |
| Example 15 | 15 | 1.50 | <0.01 | 84.0 | 82.0 | 1 |
| Comparative Example 1 | 16 | 0.32 | 1.1 | 85.2 | 82.7 | 0 |
| Comparative Example 2 | 17 | 1.26 | 1.1 | 75.0 | 80.4 | 0 |
| Comparative Example 3 | 18 | 3.60 | 0.1 | 84.3 | 78.1 | 0 |

Note that the water vapor permeability of the laminates of Examples 13 and 15 was less than the measurement limit (0.01 g/m²·day).

As shown in Table 1, the laminates of Examples 1 to 15 had an excellent gas barrier capability (small water vapor permeability) and excellent transparency (excluding the laminate 14). The conductor layer of the laminates of Examples 1 to 15 had a smooth surface and excellent conductivity.

### EXPLANATION OF SYMBOLS

1: film-shaped laminate, 2a, 2b: rotary can, 3a, 3b: feed roll, 4: plasma discharge electrode, 5a, 5b: wind-up roll, 6a, 6b: transfer roll, 7: pulse power supply, 8: target, 9: high-voltage pulse, 10a, 10b: gas inlet, 11a, 11b: chamber

## Claims

1. A laminate comprising a gas barrier layer and a conductor layer, the gas barrier layer being formed of a material that includes at least an oxygen atom, a carbon atom, and a silicon atom, the gas barrier layer having an oxygen atom content rate that gradually decreases from a surface of the gas barrier layer in a depth direction, and having a carbon atom content rate that gradually increases from the surface of the gas barrier layer in the depth direction.

2. The laminate according to claim 1, wherein the surface layer part of the gas barrier layer has an oxygen atom content rate of 10 to 70%, a carbon atom content rate of 10 to 70%, and a silicon atom content rate of 5 to 35%, based on the total content of oxygen atoms, carbon atoms, and silicon atoms.

3. The laminate according to claim 1, wherein the surface layer part of the gas barrier layer has a peak position of binding energy of 2P electron of the silicon atom determined by X-ray photoelectron spectroscopy (XPS) of 102 to 104 eV.

4. The laminate according to claim 1, further comprising an inorganic compound layer.

5. The laminate according to claim 1, wherein the gas barrier layer is a layer produced by implanting ions into a polyorganosiloxane compound-containing layer.

6. The laminate according to claim 5, wherein the ions have been produced by ionizing at least one gas selected from the group consisting of nitrogen, oxygen, argon, and helium.

7. The laminate according to claim 5, wherein the polyorganosiloxane compound is a polyorganosiloxane that includes a repeating unit shown by the following formula (a) or (b), 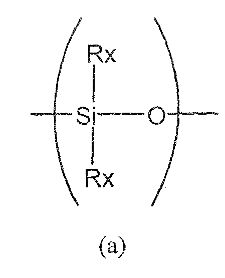 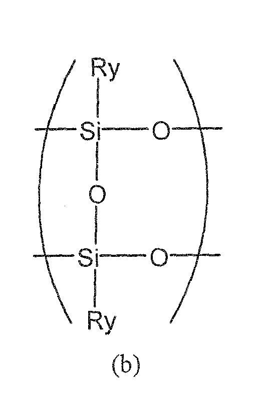 wherein Rx and Ry individually represent a hydrogen atom or a non-hydrolyzable group such as a substituted or unsubstituted alkyl group, a substituted or unsubstituted alkenyl group, or a substituted or unsubstituted aryl group, and a plurality of Rx in the formula (a) and a plurality of Ry in the formula (b) may respectively be either the same or different, provided that a case where both Rx in the formula (a) represent a hydrogen atom is excluded.

8. A method of producing a laminate including a gas barrier layer and a conductor layer, the method comprising a step (I) implanting ions into a polyorganosiloxane compound-containing layer of a formed body that includes the polyorganosiloxane compound-containing layer in its surface area to form the gas barrier layer.

9. The method according to claim 8, wherein the ions implanted in the step (I) are produced by ionizing at least one gas selected from the group consisting of nitrogen, oxygen, argon, and helium.

10. The method according to claim 8, wherein the ions are implanted in the step (I) by plasma ion implantation.

11. The method according to claim 8, wherein the ions are implanted into the polyorganosiloxane compound-containing layer in the step (I) while transferring a long formed body that includes the polyorganosiloxane compound-containing layer in its surface area in a given direction.

12. An electronic device member comprising the laminate according to any one of claims 1 to 7.

13. An electronic device comprising the electronic device member according to claim 12.
